# EUROPEAN PATENT SPECIFICATION

(11) **EP 2 226 833 B1**
(45) Date of publication and mention of the grant of the patent: **10.04.2013**
(21) Application number: 10154686.9
(22) Date of filing: 25.02.2010
(51) Int. Cl.: H01L 21/02, H01L 27/12, H01L 29/04, H01L 29/66, H01L 29/786

(54) **Method of fabricating a thin film transistor**
Herstellungsverfahren eines Dünnschichttransistors
Procédé de fabrication d'un transistor à couche mince

(30) Priority: 03.03.2009 KR 20090018201
(43) Date of publication of application: 08.09.2010
(73) Proprietor: Samsung Display Co., Ltd., Yongin-City, Gyeonggi-Do, 446-711 (KR)
(72) Inventor: Park, Byoung-Keon, Gyunggi-Do 446-711 (KR); Yang, Tae-Hoon, Gyunggi-Do 446-711 (KR); Seo, Jin-Wook, Gyunggi-Do 446-711 (KR); Lee, Ki-Yong, Gyunggi-Do 446-711 (KR); Lisachenko, Maxim, Gyunggi-Do 446-711 (KR); Choi, Bo-Kyung, Gyunggi-Do 446-711 (KR); Lee, Dae-Woo, Gyunggi-Do 446-711 (KR); Lee, Kil-Won, Gyunggi-Do 446-711 (KR); Lee, Dong-Hyun, Gyunggi-Do 446-711 (KR); Park, Jong-Ryuk, Gyunggi-Do 446-711 (KR); Ahn, Ji-Su, Gyunggi-Do 446-711 (KR); Kim, Young-Dae, Gyunggi-Do 446-711 (KR); Na, Heung-Yeol, Gyunggi-Do 446-711 (KR); Jeong, Min-Jae, Gyunggi-Do 446-711 (KR); Chung, Yun-Mo, Gyunggi-Do 446-711 (KR); Hong, Jong-Won, Gyunggi-Do 446-711 (KR); Kang, Eu-Gene, Gyunggi-Do 446-711 (KR); Chang, Seok-Rak, Gyunggi-Do 446-711 (KR); Jung, Jae-Wan, Gyunggi-Do 446-711 (KR); Yoon, Sang-Yon, Gyunggi-Do 446-711 (KR)
(74) Representative: Gulde Hengelhaupt Ziebig & Schneider

(56) References cited:
- US-A- 5 814 540
- US-A1- 2005 023 531
- US-A1- 2006 033 106
- US-A1- 2006 263 957
- US-A1- 2008 157 083

## Description

### BACKGROUND OF THE INVENTION

### 1. Field of the Invention

Aspects of the present invention relate to a thin film transistor (TFT), a method of fabricating the same, and an organic light emitting diode (OLED) display device including the same. More particularly, aspects of the present invention relate to a TFT, a method of fabricating the same, and an OLED display device including the same, where the fabrication process can remove most of a metal catalyst remaining in a semiconductor layer formed from a polycrystalline silicon layer crystallized using the metal catalyst by gettering using a metal etchant.

### 2. Description of the Related Art

Thin film transistors (TFTs) have been typically used as active elements of active matrix liquid crystal display (AMLCD) devices, and switching and driving elements of organic light emitting diode (OLED) display devices. In these cases, it is necessary to control the characteristics of the TFTs according to the required characteristics of the elements of the particular devices. One of the important factors which determine the characteristics of the TFTs is leakage current.

In general, in a TFT having a semiconductor layer formed of a polycrystalline silicon layer which is crystallized by a crystallization method that does not use a metal catalyst, the leakage current tends to increase when the width of a channel region increases and tends to decrease when the length of the channel region increases. However, even though the length of the channel region is increased in order to reduce the leakage current, the effect is minor. Moreover, in a display device, if the length of the channel region is increased, the size of the entire device is also increased, and the aperture ratio is reduced. Thus, the length of the channel region is limited.

Recently, methods of crystallizing an amorphous silicon layer using a metal catalyst have been extensively studied, since the methods have advantages in that the crystallization can be achieved at a lower temperature over a shorter crystallization time than in a solid phase crystallization (SPC) method. Also, a broader range of process conditions can be used and the reproducibility is higher than in an excimer laser crystallization (ELC) method.

Examples of TFTs of the prior art and method of producing the same are disclosed in US 2005/023531 A1, US 5,814,540 A, US 2006/033106A1 and US 2008/157083A1.

However, in a TFT using a polycrystalline silicon layer that has been crystallized using a metal catalyst as a semiconductor layer, the leakage current of the TFT as a function of changes in the length or width of the channel region changes without a clear tendency, unlike the tendency that other TFTs demonstrate. Accordingly, a TFT having a semiconductor layer formed of a polycrystalline silicon layer crystallized using a metal catalyst has problems in that the leakage current as a function of the size of the channel region of the semiconductor layer cannot be estimated, and the size of the channel region of the semiconductor layer, which will be used to control the leakage current, cannot be determined.

### SUMMARY OF THE INVENTION

Aspects of the present invention provide a method of fabricating a thin film transistor (TFT) as defined in the claims. The fabrication process can remove most of a metal catalyst remaining in a semiconductor layer formed of a polycrystalline silicon layer crystallized using the metal catalyst by gettering using a metal etchant, thus improving the characteristics of the TFT.

According to an exemplary embodiment, a TFT includes: a substrate; a buffer layer disposed on the substrate; a semiconductor layer disposed on the buffer layer; a gate electrode insulated from the semiconductor layer; a gate insulating layer insulating the semiconductor layer from the gate electrode; and source and drain electrodes insulated from the gate electrode and partially connected to the semiconductor layer, wherein the semiconductor layer comprises at least one groove.

According to another exemplary embodiment, an OLED display device includes: a substrate; a buffer layer disposed on the substrate; a semiconductor layer disposed on the buffer layer; a gate electrode insulated from the semiconductor layer; a gate insulating layer insulating the semiconductor layer from the gate electrode; source and drain electrodes insulated from the gate electrode and partially connected to the semiconductor layer; an insulating layer disposed on the entire surface of the substrate; a first electrode disposed on the insulating layer and electrically connected to one of the source and drain electrodes; an organic layer; and a second electrode, wherein the semiconductor layer comprises at least one groove.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIGs. 1A to 1D are cross-sectional views illustrating a crystallization process according to an exemplary embodiment of the present invention for a polycrystalline silicon layer;
FIGs. 2A and 2B are cross-sectional views illustrating gettering on a polycrystalline silicon layer;
FIG. 2C is a photograph of the surface of a polycrystalline silicon layer taken after gettering according to the embodiment of FIGs. 2A and 2B;
FIGs. 2D to 2F are graphs of metal catalyst concentrations of polycrystalline silicon layers to which gettering has been applied, according to the embodiment of FIGs. 2A and 2B;
FIGs. 3A to 3C are cross-sectional views illustrating a process of fabricating a top-gate TFT according to another exemplary embodiment of the present invention;
FIGs. 4A to 4C are cross-sectional views illustrating a process of fabricating a bottom-gate TFT according to another exemplary embodiment of the present invention; and
FIG. 5 is a cross-sectional view of an OLED display device.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

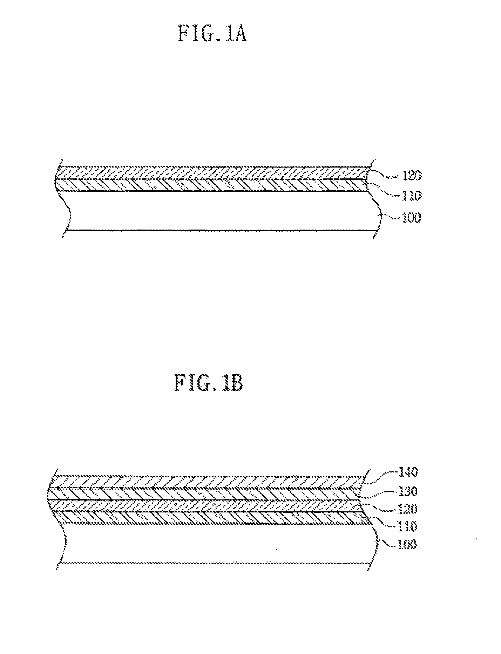

FIGs. 1A to 1D are cross-sectional views illustrating a crystallization process according to an exemplary embodiment of the present invention for a polycrystalline silicon layer. First, as illustrated in FIG. 1A, a buffer layer 110 is formed on a substrate 100 that is formed of glass or plastic. The buffer layer 110 is an insulating layer and may be formed of a silicon dioxide layer, a silicon nitride layer, or a combination thereof, by chemical vapor deposition (CVD) or physical vapor deposition (PVD). The buffer layer 110 serves to prevent diffusion of moisture or impurities generated in the substrate 100 and to adjust the heat transfer rate during crystallization, thereby facilitating crystallization of an amorphous silicon layer. However, the buffer layer 110 is not required in all aspects of the present invention.

Subsequently, an amorphous silicon layer 120 is formed on the buffer layer 110. The amorphous silicon layer 120 may be deposited by CVD or PVD. During or after the formation of the amorphous silicon layer 120, a dehydrogenation process may be performed to reduce the concentration of hydrogen.

Then, the amorphous silicon layer 120 is crystallized into a polycrystalline silicon layer. According to aspects of the present invention, the amorphous silicon layer is crystallized into a polycrystalline silicon layer by a crystallization method using a metal catalyst, such as a metal induced crystallization (MIC) technique, a metal induced lateral crystallization (MILC) technique, or a super grain silicon (SGS) technique. However, the crystallization techniques are not limited thereto.

The SGS technique is a method of crystallizing an amorphous silicon layer 120 in which the concentration of the metal catalyst diffused into the amorphous silicon layer 120 is lowered in order to control the grain size of the polycrystalline silicon to be within the range of several µm to several hundreds of µm. To lower the concentration of the metal catalyst diffused into the amorphous silicon layer 120, a diffusion layer 130 (see FIG. 1 B) is formed on the amorphous silicon layer 120, and a metal catalyst layer 140 (see FIG. 1 B) is formed on the diffusion layer 130 and annealed to diffuse the metal catalyst into the amorphous silicon layer 120.

In an exemplary embodiment of the present invention, the polycrystalline silicon layer is formed by an SGS crystallization technique, which will now be described. FIG. 1 B is a cross-sectional view illustrating a process of forming a diffusion layer 130 and a metal catalyst layer 140 on the amorphous silicon layer 120. The diffusion layer 130 is formed on the amorphous silicon layer 120. The diffusion layer 130 is formed in a double-layered structure of the silicon nitride layer and the silicon dioxide layer and any one of the layers is patterned to adjust the position where the metal catalyst is diffused. The diffusion layer 130 may be formed by any suitable deposition method such as, for example, CVD or PVD.

In the example shown, the diffusion layer 130 may be formed to a thickness of 0.1 through 200 nm. When the thickness of the diffusion layer 130 is less than 0.1 nm, it may be difficult to control the amount of metal catalyst that diffuses through the diffusion layer 130. When the thickness of the diffusion layer 130 is more than 200 nm, the amount of metal catalyst diffused into the amorphous silicon layer 120 may be too small, and thus it is difficult to crystallize the amorphous silicon layer 120 into a polycrystalline silicon layer.

Subsequently, a metal catalyst is deposited on the diffusion layer 130 to form a metal catalyst layer 140. The metal catalyst may be selected from the group consisting of nickel (Ni), palladium (Pd), silver (Ag), gold (Au), aluminum (Al), tin (Sn), antimony (Sb), copper (Cu), terbium (Tb), and cadmium (Cd), and preferably the metal catalyst may be Ni. The metal catalyst layer 140 may be formed to have a surface density of 10¹¹ through 10¹⁵ atoms/cm² on the diffusion layer 130. When the metal catalyst layer 140 is formed with a surface density of less than 10¹¹ atoms/cm², the number of seeds, which act as nuclei for crystallization, may be too small, and thus it may be difficult to crystallize the amorphous silicon layer into a polycrystalline silicon layer by the SGS crystallization technique. When the metal catalyst layer 140 is formed with a surface density of more than 10¹⁵ atoms/cm², the amount of metal catalyst diffused into the amorphous silicon layer 120 is too large, and thus the grains produced in the polycrystalline silicon layer are smaller in size. Moreover, the amount of metal catalyst remaining in the polycrystalline silicon layer also increases, and thus the characteristics of a semiconductor layer formed by patterning the polycrystalline silicon layer may be poorer.

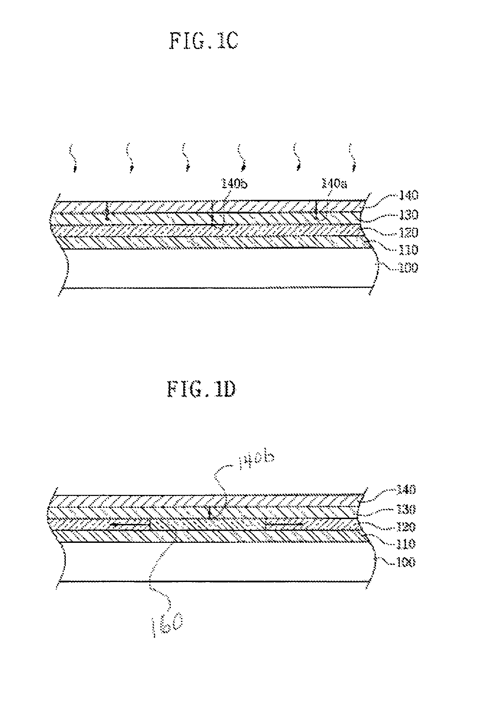

FIG. 1C is a cross-sectional view illustrating a process of diffusing the metal catalyst through the diffusion layer 130 to an interface of the amorphous silicon layer 120 by annealing the substrate 110. Referring to FIG. 1C, the substrate 100, on which the buffer layer 110, the amorphous silicon layer 120, the diffusion layer 130, and the metal catalyst layer 140 are formed, is annealed to move some of the metal catalyst of the metal catalyst layer 140 to the surface of the amorphous silicon layer 120. That is, only a very small amount of metal catalyst 140b from the metal catalyst layer 140 diffuses through the diffusion layer 130 to the surface of the amorphous silicon layer 120 during the annealing, and most of the metal catalyst 140a does not reach the amorphous silicon layer 120, or does not pass at all through the diffusion layer 130. Thus, the amount of metal catalyst 140b reaching the surface of the amorphous silicon layer 120 is determined by the diffusion blocking ability of the diffusion layer 130, which is closely related to the thickness of the diffusion layer 130. That is, as the thickness of the diffusion layer 130 increases, the diffused amount of the metal catalyst 140b decreases, and thus the produced grains become larger. On the other hand, if the thickness of the diffusion layer 130 decreases, the diffused amount of the metal catalyst 140b increases, and thus the produced grains become smaller.

The annealing process may be performed at a temperature of about 200 to about 900 °C, preferably at a temperature of about 350 to about 500 °C for several seconds to several hours to diffuse the metal catalyst. Under the annealing conditions described above, it is possible to prevent deformation of the substrate 100 caused by excessive annealing, and to lower production costs and increase yield. The annealing process may be one of a furnace process, a rapid thermal annealing (RTA) process, a UV process, and a laser process.

FIG. 1D is a cross-sectional view illustrating a process of crystallizing the amorphous silicon layer 120 into a polycrystalline silicon layer 160 by using the diffused metal catalyst. Referring to FIG. 1D, the amorphous silicon layer 120 is crystallized into a polycrystalline silicon layer 160 by the metal catalyst 140b that has diffused to the surface of the amorphous silicon layer 120 through the diffusion layer 130. That is, the diffused metal catalyst 140b is bonded to silicon of the amorphous silicon layer 120 to form metal silicides, which form seeds, i.e., nuclei for crystallization, and thus the amorphous silicon layer 120 is crystallized into the polycrystalline silicon layer 160.

As illustrated in FIG. 1D, the annealing process is performed without removing the diffusion layer 130 and the metal catalyst layer 140. Alternatively, the polycrystalline silicon layer may be formed by diffusing the metal catalyst 140b onto the amorphous silicon layer 120 to form metal silicides, which are nuclei for crystallization, removing the diffusion layer 130 and the metal catalyst layer 140, and then annealing the bared amorphous silicon layer 120.

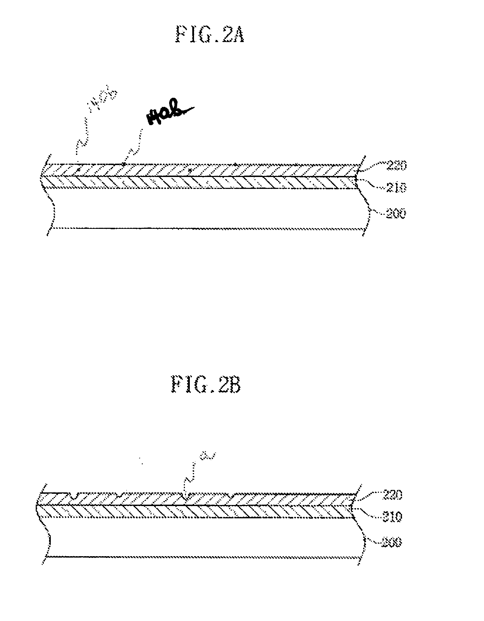

FIGs. 2A and 2B are cross-sectional views illustrating gettering on a polycrystalline silicon layer. First, as illustrated in FIG. 2A, a buffer layer 210 and a polycrystalline silicon layer 220 crystallized using the metal catalyst according to FIGs.1 A through 1D have been formed on a substrate 200.
Here, the exemplary gettering that follows is performed on the substrate 200, from which the diffusion layer 130 and the metal catalyst layer 140 illustrated in FIG. 1D have been deleted from FIGs. 2A and 2B for purposes of explanation.

The polycrystalline silicon layer 220 contains residual metal catalyst 140b, and the concentration of the residual metal catalyst 140b after the crystallization is about 1×10¹³ to 5×10¹⁴ atoms/cm². The polycrystalline silicon layer 220 is etched with an etchant.

The etchant used is to remove nickel or nickel silicide and includes a mixture of 25% hydrochloric acid (HCl), 10% acetic acid (CH₃COOH), and ferric chloride at various concentrations. Moreover, buffered oxide etch (BOE) such as HF or NH₄F may be used. When the etchant is used to etch the polycrystalline silicon layer 220 for about 2 minutes, the residual metal catalysts are dissolved in the etchant, thus allowing the gettering process to proceed.

Referring to FIG. 2B, when the substrate 200 on which the polycrystalline silicon layer 220 has been formed is etched, the residual metal catalyst 140b present in the polycrystalline silicon layer 220 is removed. Especially, the metal silicide at the grain interface is dissolved in the etchant and removed, and thus grooves or indentations "a" are formed. The formed indentations "a" have various sizes according to the initial concentration of the metal catalyst and the temperature and time of the crystallization annealing process. The indentations "a" may have sizes in the range of about 200 to about 1,000 nm, and fine holes may be formed.

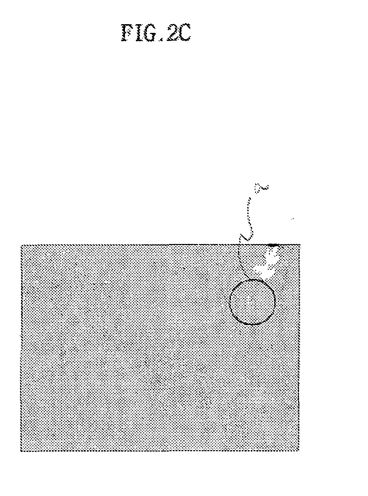

FIG. 2C is a photograph of the surface of the polycrystalline silicon layer 220 taken after gettering with the etchant as illustrated in FIG. 2B, from which it can be seen that the indentations "a" are formed after the aggregated metal catalyst and metal silicide are removed.

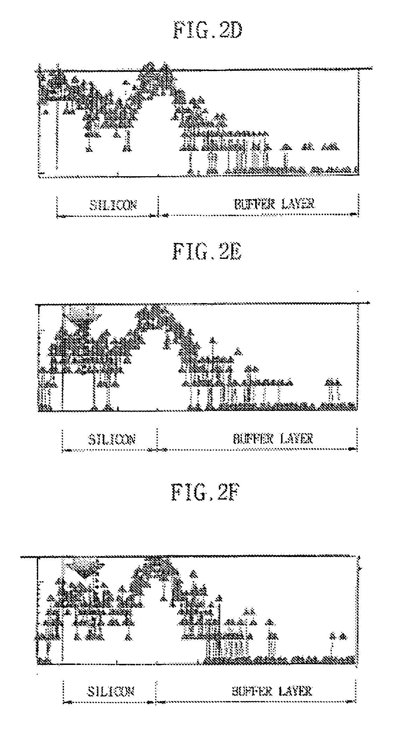

FIGs. 2D to 2F are graphs of metal catalyst concentrations of the polycrystalline silicon layers to which gettering has been applied, in which the crystallization is performed using nickel as the metal catalyst. FIG. 2D shows the concentration of nickel catalyst of the polycrystalline silicon layer measured before gettering, FIG. 2E shows the concentration of nickel catalyst of the polycrystalline silicon layer measured after gettering for 1 minute, and FIG. 2F shows the concentration of nickel catalyst of the polycrystalline silicon layer measured after gettering for 2 minutes.

Referring to FIGs. 2D to 2F, when comparing the amounts of nickel catalyst before and after gettering for 1 and 2 minutes, it can be seen that the amount of nickel catalyst on the surface of the polycrystalline silicon layer is reduced after gettering has been applied for 1 minute (B) and the amount of nickel catalyst is also reduced after gettering has been applied for 2 minutes (C).

Although the grooves are formed on the surface of the polycrystalline silicon layer after gettering, the grooves have no significant effect on the characteristics of a semiconductor layer formed from the polycrystalline silicon layer.

Table 1 shows the characteristics of the semiconductor layer formed from the polycrystalline silicon layer 160 after gettering.

**Table 1**

| Number of indentations | Threshold voltage (Vth)(V) | Off-current (loff)(A/µm) |
|---|---|---|
| 4 | 2.01 | 2x10⁻¹¹ |
| 6 | 1.99 | 1x10⁻¹¹ |
| 8 | 1.98 | 1x10⁻¹¹ |

It can be seen from Table 1 that although the indentations "a" are present on the surface of the polycrystalline silicon layer, the threshold voltage (Vth) characteristics and the off-current (loff) characteristics are excellent. Thus, it is possible to effectively remove the metal catalyst by the above-described gettering.

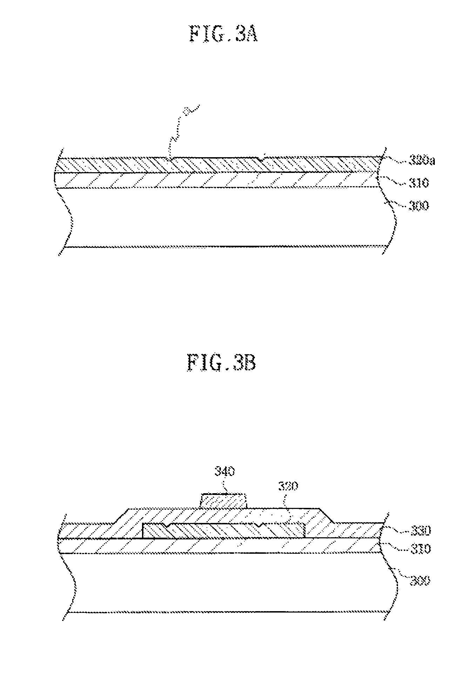

FIGs. 3A to 3C are cross-sectional views illustrating a process of fabricating a top-gate TFT according to another exemplary embodiment of the present invention using the process of fabricating the polycrystalline silicon layer. Referring to FIG. 3A, a buffer layer 310 may be formed on a substrate 300 that is formed of glass, stainless steel, or plastic. The buffer layer 310 is an insulating layer and may be formed of a silicon dioxide layer, a silicon nitride layer, or a combination thereof. The buffer layer 310 serves to prevent diffusion of moisture or impurities generated in the substrate 300 and to adjust the heat transfer rate during crystallization, thereby facilitating crystallization of an amorphous silicon layer.

Subsequently, to form a polycrystalline silicon layer 320a, an amorphous silicon layer is formed on the buffer layer 310. In the same manner as the exemplary embodiment of FIGS. 1A to 1D, the amorphous silicon layer is crystallized into a polycrystalline silicon layer 320a using a metal catalyst. Then, the polycrystalline silicon layer 320a is subjected to the above-described gettering of FIGs. 2A and 2B using a metal etchant to remove residual metal catalysts, thereby forming a polycrystalline silicon layer 320a having indentations "a" formed with the metal catalyst.

Referring to FIG. 3B, a semiconductor layer 320 is formed on the buffer layer 310 by patterning the polycrystalline silicon layer 320a. Then, a gate insulating layer 330 is formed on the entire surface of the substrate 300 including the semiconductor layer 320. The gate insulating layer 330 may be a silicon dioxide layer, a silicon nitride layer, or a combination thereof.

Subsequently, a metal layer for a gate electrode (not shown) is formed on the gate insulating layer 330 using a single layer of aluminum (Al) or an Al alloy such as aluminum-neodymium (Al-Nd), or a multi-layer having an Al alloy stacked on a chrome (Cr) or molybdenum (Mo) alloy, and a gate electrode 340 is formed to correspond to a channel region of the semiconductor layer 320 by etching the metal layer for a gate electrode using a photolithography process.

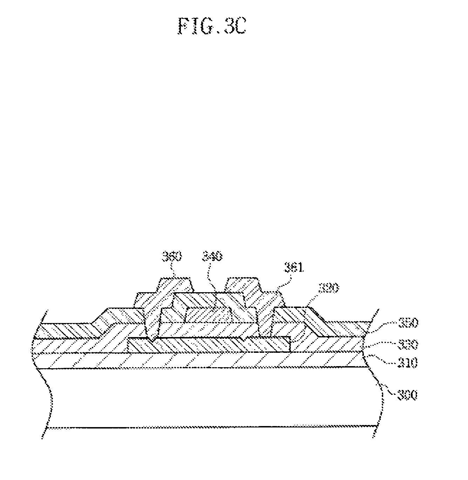

Then, referring to FIG. 3C, an interlayer insulating layer 350 is formed on the entire surface of the substrate 300 including the gate electrode 340. Here, the interlayer insulating layer 350 may be formed of a silicon dioxide layer, a silicon nitride layer, or a combination thereof.

Next, the interlayer insulating layer 350 and the gate insulating layer 330 are etched to form contact holes exposing source and drain regions of the semiconductor layer 320. Source and drain electrodes 360 and 361 connected to the source and drain regions through the contact holes are formed. In this case, the source and drain electrodes 360 and 361 may be formed of one selected from the group consisting of molybdenum (Mo) or a molybdenum (Mo) alloy, chromium (Cr), tungsten (W) or a (W) tungsten alloy, molybdenum-tungsten (MoW), aluminum (Al) or an aluminum alloy, aluminum-neodymium (Al-Nd), titanium (Ti), titanium-nitride (TiN), or copper (Cu) or a copper (Cu) alloy,. Further examples include an alloy of molybdenum-tungsten (MoW), an alloy of aluminum-neodymium (AlNd), or titanium-nitride (TiN). Thus, a TFT including the semiconductor layer 320, the gate electrode 340, and the source and drain electrodes 360 and 361 is completed.

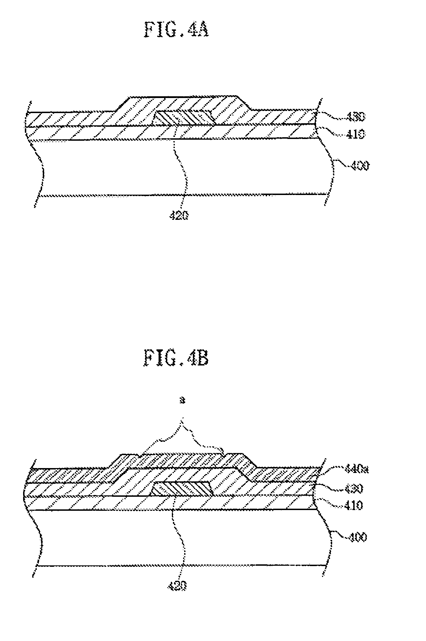

FIGs. 4A to 4C are cross-sectional views illustrating a process of fabricating a bottom-gate TFT according to another exemplary embodiment of the present invention using the process of fabricating the polycrystalline silicon layer. Except for particular descriptions below, the process will be described with reference to the descriptions in the above exemplary embodiment.

Referring to FIG. 4A, a buffer layer 410 is formed on a substrate 400. To form a gate electrode 420, a metal layer is formed on the buffer layer 410, and a gate electrode 420 is formed by etching the metal layer for a gate electrode using a photolithography process. Then, a gate insulating layer 430 is formed on the substrate 400 including the gate electrode 420.

Subsequently, referring to FIG. 4B, an amorphous silicon layer is formed on the gate insulating layer 430 and then crystallized into a polycrystalline silicon layer 440a using a metal catalyst in the same manner as the exemplary embodiment of FIGS. 1 A through 1 D. The polycrystalline silicon layer 440a is subjected to the gettering described in the exemplary embodiment of FIGs. 2A and 2B such that the metal catalyst in the polycrystalline silicon layer 440a is removed by the gettering, and thus grooves or indentations "a" remain.

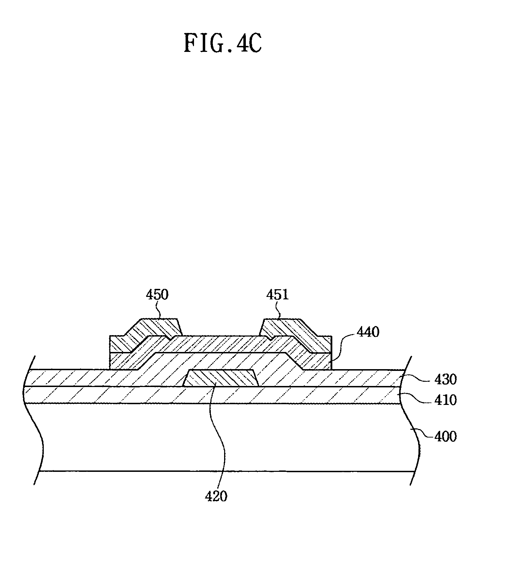

Referring to FIG. 4C, a semiconductor layer 440 is formed by patterning the polycrystalline silicon layer 440a. Then, source and drain conductive layers are formed on the semiconductor layer 440 and patterned to form source and drain electrodes 450 and 451. In this case, the source and drain electrodes 450 and 451 may be formed of one selected from the group consisting of molybdenum (Mo) or a molybdenum (Mo) alloy, chromium (Cr), tungsten (W) or a (W) tungsten alloy, molybdenum-tungsten (MoW), aluminum (Al) or an aluminum alloy, aluminum-neodymium (Al-Nd), titanium (Ti), titanium-nitride (TiN), or copper (Cu) or a copper (Cu) alloy,. Further examples include an alloy of molybdenum-tungsten (MoW), an alloy of aluminum-neodymium (AlNd), or titanium-nitride (TiN). Thus, a TFT including the semiconductor layer 440, the gate electrode 420, and the source and drain electrodes 450 and 451 is completed.

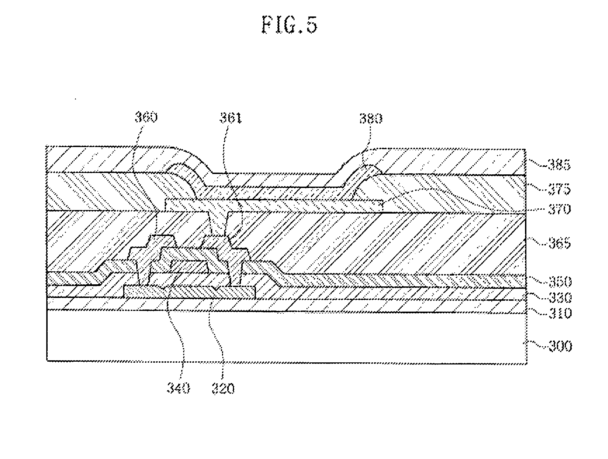

FIG. 5 is a cross-sectional view of an OLED display device including a top-gate TFT produced according to a method of the present invention. Referring to FIG. 5, an insulating layer 365 is formed on the entire surface of the substrate 300 including the TFT produced according to the method exemplified in FIGS. 3A to 3C. The insulating layer 365 may be an inorganic layer formed of a material selected from the group consisting of silicon dioxide, silicon nitride, and silicate on glass, or an organic layer formed of a polymer selected from the group consisting of a polyimide, a poly(benzocyclobutene), and a polyacrylate. Also, the insulating layer 365 may be formed by stacking the inorganic layer and the organic layer.

A via hole exposing the source or drain electrode 360 or 361 is formed by etching the insulating layer 365. A first electrode 370 connected to one of the source and drain electrodes 360 and 361 through the via hole is formed. The first electrode 370 may be an anode or a cathode. When the first electrode 370 is an anode, the anode may be formed of a transparent conductive layer formed of ITO, IZO, or ITZO, and when the first electrode 370 is a cathode, the cathode may be formed of Mg, Ca, Al, Ag, Ba, or an alloy thereof.

Subsequently, a pixel defining layer 375 having an opening that partially exposes the surface of the first electrode 370 is formed on the first electrode 370, and an organic layer 380 including an emission layer is formed on the exposed first electrode 370. The organic layer 380 may further include at least one of a hole injection layer, a hole transport layer, a hole blocking layer, an electron blocking layer, an electron injection layer, and an electron transport layer. Then, a second electrode 385 is formed on the organic layer 380. Thus, an OLED display device is completed.

According to aspects of the present invention as described above, it is possible to remove most of a metal catalyst remaining in a semiconductor layer formed from a polycrystalline silicon layer crystallized using the metal catalyst by gettering using a metal etchant, and thus a TFT having excellent electrical characteristics, a method of fabricating the same, and an OLED display device including the same may be provided.

## Claims

1. A method of manufacturing a polycrystalline silicon layer (160,220) comprising the following sequence of steps:
forming a buffer layer (110,210) on a substrate (100,200),
forming an amorphous silicon layer (120) on the buffer layer (110,210),
forming a diffusion layer (130) on the amorphous silicon layer (120), wherein the diffusion layer (130) is formed in a double-layered structure of a silicon nitride layer and a silicon dioxide layer and wherein any one of said layers is patterned to adjust the position where a metal catalyst is to be diffused through said diffusion layer (130) to said amorphous silicon layer(120),
forming a metal catalyst layer (140) on the diffusion layer (130),
crystallizing the amorphous silicon layer (120) into polycrystalline silicon layer (160,220) by annealing the substrate (100,200),
removing the diffusion layer (130) and the metal catalyst layer (140), and
etching the polycrystalline silicon layer (160,220) using an etchant.

2. The method of claim 1, wherein the polycrystalline silicon layer (160, 220) at least one indentation, and each indentation has a size of 200 to 1,000 nm.

3. A method of fabricating a top gate thin film transistor, comprising the following sequence of steps:
forming a buffer layer (310) on a substrate (300),
forming an amorphous silicon layer on the buffer layer (310),
forming a diffusion layer on the amorphous silicon layer, wherein the diffusion layer is formed in a double-layered structure of a silicon nitride layer and a silicon dioxide layer and wherein any one of said layers is patterned to adjust the position where a metal catalyst is to be diffused through said diffusion layer to said amorphous silicon layer,
forming a metal catalyst layer on the diffusion layer,
crystallizing the amorphous silicon layer into a polycrystalline silicon layer (320d) by annealing the substrate (300),
removing the diffusion layer and the metal catatyst layer, and
etching the polycrystalline silicon layer (320d) using an etchant;
forming a semiconductor layer (320) by patterning the polycrystalline silicon layer (320a);
forming a gate insulating layer (330) on the semiconductor layer (320);
forming a gate electrode (340) on the gate insulating layer (330);
forming an interlayer insulating layer (350) on the entire surface of the substrate (300); and
forming source and drain electrodes (360,361) on the interlayer insulating layer (350) to be partially connected to the semiconductor layer (320).

4. A method of fabricating a bottom gate thin film transistor, comprising the following sequence of steps:
forming a buffer layer (410) on a substrater (400);
forming a gate electrode (420) on the buffer layer (410);
forming a gate insulating layer (430)on the entire surface of the substrate (400);
forming an amorphous silicon layer on the gate insulating layer (430),
forming a diffusion layer on the amorphous silicon layer, wherein the diffusion layer is formed in a double-layered structure of a silicon nitride layer and a silicon dioxide layer and wherein any one of said layers is patterned to adjust the position where a metal catalyst is to be diffused through said diffusion layer to said amorphous silicon layer,
forming a metal catalyst layer on the diffusion layer,
crystallizing the amorphous silicon layer into a polycrystalline silicon layer (440a) by annealing the substrat (400),
removing the diffusion layer and the metal catalyst layer, and
etching the polycrystalline silion layer (440a) using an etchant;
forming a semiconductor layer (440) corresponding to the gate electrode (420) by patterning the polycrystalline siliconlayer (440a) ; and
forming source and drain electrodes (450,451) exposing a portion of the semiconductor layer (440) and connected to the semiconductor layer (440).

5. The method of claim 3 or 4, wherein the etchant is at least one material selected from the group consisting of hydrochloric acid, acetic acid, ferric chloride, and buffered oxide etch.

6. The method of one of claims 3 to 5, wherein the metal catalyst layer is formed of a metal selected from the group consisting of nickel (Ni), palladium (Pd), silver (Ag), gold (Au), aluminum (Al), tin (Sn), antimony (Sb), copper (Cu), terbium (Tb), and cadmium (Cd).

7. The method of one of claims 3 to 6, wherein the annealing is performed at a temperature of 350 to 500 ºC.

8. The method of claim 5, wherein the buffered oxide etch is a mixture of HF and NH₄F.

9. The method of claim 3 or 4, wherein the thickness of the diffusion layer is 0.1 through 200 nm.

## Patentansprüche

1. Verfahren zur Herstellung einer polykristallinen Siliziumschicht (160, 220), aufweisend die folgende Abfolge von Schritten:
Ausbildung einer Pufferschicht (110, 210) auf einem Substrat (100, 200);
Ausbildung einer amorphen Siliziumschicht (120) auf der Pufferschicht (110, 210);
Ausbildung einer Diffusionsschicht (130) auf der amorphen Siliziumschicht (120), wobei die Diffusionsschicht (130) in einer doppelschichtigen Struktur aus einer Siliziumnitridschicht und einer Siliziumdioxidschicht ausgebildet wird, und wobei irgendeine der besagten Schichten gemustert wird, so dass die Position eingestellt wird, in der ein Metallkatalysator durch die besagte Diffusionsschicht (130) zur besagten amorphen Siliziumschicht (120) diffundieren soll;
Ausbildung einer Metallkatalysatorschicht (140) auf der Diffusionsschicht (130);
Kristallisation der amorphen Siliziumschicht (120) zu einer polykristallinen Siliziumschicht (160, 220) durch Glühen des Substrats (100, 200);
Entfernen der Diffusionsschicht (130) und der Metallkatalysatorschicht (140); und
Ätzen der polykristallinen Siliziumschicht (160, 220) mittels eines Ätzmittels.

2. Verfahren nach Anspruch 1, wobei die polykristalline Siliziumschicht (160, 220) zumindest eine Vertiefung aufweist, und wobei jede Vertiefung eine Größe von 200 bis 1000 nm aufweist.

3. Verfahren zur Herstellung eines Top-Gate-Dünnschichttransistors, aufweisend die folgende Abfolge von Schritten:
Ausbildung einer Pufferschicht (310) auf einem Substrat (300);
Ausbildung einer amorphen Siliziumschicht auf der Pufferschicht (8);
Ausbildung einer Diffusionsschicht auf der amorphen Siliziumschicht, wobei die Diffusionsschicht in einer doppelschichtigen Struktur aus einer Siliziumnitridschicht und einer Siliziumdioxidschicht ausgebildet wird, und wobei irgendeine der besagten Schichten gemustert wird, so dass die Position eingestellt wird, in der ein Metallkatalysator durch die besagte Diffusionsschicht zur besagten amorphen Siliziumschicht diffundieren soll;
Ausbildung einer Metallkatalysatorschicht auf der Diffusionsschicht;
Kristallisation der amorphen Siliziumschicht zu einer polykristallinen Siliziumschicht (320a) durch Glühen des Substrats (300);
Entfernen der Diffusionsschicht und der Metallkatalysatorschicht; und
Ätzen der polykristallinen Siliziumschicht (320a) mittels eines Ätzmittels;
Ausbildung einer Halbleiterschicht (320) durch Mustern der polykristallinen Siliziumschicht (320a);
Ausbildung einer Gate-Isolierschicht (330) auf der Halbleiterschicht (320);
Ausbildung einer Gate-Elektrode (340) auf der Gate-Isolierschicht (330);
Ausbildung einer Zwischenschicht-Isolierschicht (350) auf der Gesamtfläche des Substrats (300); und
Ausbildung einer Source- und einer Drain-Elektrode (360, 361) auf der Zwischenschicht-Isolierschicht (350), die teilweise mit der Halbleiterschicht (320) verbunden werden.

4. Verfahren zur Herstellung eines Bottom-Gate-Dünnschichttransistors, aufweisend die folgende Abfolge von Schritten:
Ausbildung einer Pufferschicht (410) auf einem Substrat (400);
Ausbildung einer Gate-Elektrode (420) auf der Pufferschicht (410);
Ausbildung einer Gate-Isolierschicht (430) auf der Gesamtfläche des Substrats (400);
Ausbildung einer amorphen Siliziumschicht auf der Gate-Isolierschicht (430);
Ausbildung einer Diffusionsschicht auf der amorphen Siliziumschicht, wobei die Diffusionsschicht in einer doppelschichtigen Struktur aus einer Siliziumnitridschicht und einer Siliziumdioxidschicht ausgebildet wird, und wobei irgendeine der besagten Schichten gemustert wird, so dass die Position eingestellt wird, in der ein Metallkatalysator durch die besagte Diffusionsschicht zur besagten amorphen Siliziumschicht diffundieren soll;
Ausbildung einer Metallkatalysatorschicht auf der Diffusionsschicht;
Kristallisation der amorphen Siliziumschicht zu einer polykristallinen Siliziumschicht (440a) durch Glühen des Substrats (400);
Entfernen der Diffusionsschicht und der Metallkatalysatorschicht; und
Ätzen der polykristallinen Siliziumschicht (440a) mittels eines Ätzmittels;
Ausbildung einer Halbleiterschicht (440), die mit der Gate-Elektrode (420) korrespondiert, durch Mustern der polykristallinen Siliziumschicht (440a); und
Ausbildung einer Source- und einer Drain-Elektrode (450, 451), die einen Abschnitt der Halbleiterschicht (440) freilegen und mit der Halbleiterschicht (440) verbunden sind.

5. Verfahren nach Anspruch 3 oder 4, wobei das Ätzmittel zumindest ein Material ist, das aus der Gruppe bestehend aus Salzsäure, Essigsäure, Eisen(III)-chlorid und gepufferter Flusssäure ausgewählt ist.

6. Verfahren nach einem der Ansprüche 3 bis 5, wobei die Metallkatalysatorschicht aus einem Metall ausgebildet wird, das aus der Gruppe bestehend aus Nickel (Ni), Palladium (Pd), Silber (Ag), Gold (Au), Aluminium (Al), Zinn (Sn), Antimon (Sb), Kupfer (Cu), Terbium (Tb) und Kadmium (Cd) ausgewählt ist.

7. Verfahren nach einem der Ansprüche 3 bis 6, wobei das Glühen bei einer Temperatur von 350 bis 500 °C durchgeführt wird.

8. Verfahren nach Anspruch 5, wobei die gepufferte Flusssäure eine Mischung aus HF und NH₄F ist.

9. Verfahren nach Anspruch 3 oder 4, wobei die Dicke der Diffusionsschicht 0,1 bis 200 nm beträgt.

## Revendications

1. Procédé pour la production d'une couche de silicium polycristallin (160, 220), comprenant la séquence d'étapes suivants :
formation d'une couche tampon (110, 210) sur le substrat (100, 200),
formation d'une couche de silicium amorphe (120) sur la couche tampon (110, 210),
formation d'une couche de diffusion (130) sur la couche de silicium amorphe (120), ladite couche de diffusion (130) étant formée suivant une structure double couche d'une couche de nitrure de silicium et d'une couche de dioxyde de silicium, et n'importe laquelle desdites couches étant munie d'un motif pour ajuster la position où un catalyseur métallique doit être amené à diffuser à travers ladite couche de diffusion (130) jusqu'à ladite couche de silicium amorphe (120),
la formation d'une couche de catalyseur métallique (140) sur la couche de diffusion (130),
la cristallisation de la couche de silicium amorphe (120) en une couche de silicium polycristallin (160, 220), par recuit du substrat (100, 200),
l'élimination de la couche de diffusion (130) et de la couche de catalyseur métallique (140), et
l'attaque chimique de la couche de silicium polycristallin (1) en utilisant un agent d'attaque chimique.

2. Procédé suivant la revendication 1, dans lequel la couche de silicium polycristallin (160, 220) comprend au moins une indentation, et chaque indentation a une dimension de 200 à 1000 nm.

3. Procédé pour la fabrication d'un transistor à couches minces à grille supérieure, comprenant la séquence d'étapes suivante :
formation d'une couche tampon (310) sur un substrat (300),
formation d'une couche de silicium amorphe sur la couche tampon (310),
formation d'une couche de diffusion sur la couche de silicium amorphe, ladite couche de diffusion étant formée suivant une structure double couche d'une couche de nitrure de silicium et d'une couche de dioxyde de silicium, et n'importe laquelle desdites couches étant munie d'un motif pour ajuster la position où un catalyseur métallique doit être amené à diffuser à travers ladite couche de diffusion jusqu'à ladite couche de silicium amorphe,
la formation d'une couche de catalyseur métallique sur la couche de diffusion,
la cristallisation de la couche de silicium amorphe en une couche de silicium polycristallin (320a) par recuit du substrat (300),
l'élimination de la couche de diffusion et de la couche de catalyseur métallique, et
l'attaque chimique de la couche de silicium polycristallin (320a) en utilisant un agent d'attaque chimique,
une formation d'une couche de semiconducteur (320) en munissant d'un motif la couche de silicium polycristallin (320a),
la formation d'une couche d'isolation de grille (330) sur la couche de semiconducteur (320),
la formation d'une électrode de grille (340) sur la couche d'isolation de grille (330),
la formation d'une couche isolante intermédiaire (350) sur la surface totale du substrat (300), et
la formation d'électrodes de source et de drain (360, 361) sur la couche isolante intermédiaire (350) de telle sorte qu'elles soient partiellement connectées à la couche de semiconducteur (320).

4. Procédé pour la fabrication d'un transistor à couches minces à grille inférieure, comprenant la séquence d'étapes suivante :
formation d'une couche tampon (410) sur un substrat (400),
formation d'une électrode de grille (420) sur la couche tampon (410),
formation d'une couche isolante de grille (430) sur la surface totale du substrat (400),
formation d'une couche de silicium amorphe sur la couche d'isolation de grille (430),
formation d'une couche de diffusion sur la couche de silicium amorphe, ladite couche de diffusion étant formée en une structure double couche d'une couche de nitrure de silicium et d'une couche de dioxyde de silicium, et n'importe laquelle desdites couches étant munie d'un motif pour ajuster la position où un catalyseur métallique doit être amené à diffuser à travers ladite couche de diffusion jusqu'à ladite couche de silicium amorphe,
formation d'une couche de catalyseur métallique sur la couche de diffusion,
cristallisation de la couche de silicium amorphe en une couche de silicium polycristallin (440a) par recuit du substrat (400),
élimination de la couche de diffusion et de la couche de catalyseur métallique, et
attaque chimique de la couche de silicium polycristallin (440a) en utilisant un agent d'attaque chimique,
formation d'une couche de semiconducteur (440) correspondant à l'électrode de grille (420) en munissant d'un motif la couche de silicium polycristallin (440a) ; et
formation d'électrodes de source et de drain (450, 451) en exposant une portion de la couche de semiconducteur (440), connectées à la couche de semiconducteur (440).

5. Procédé suivant la revendication 3 ou 4, dans lequel l'agent d'attaque chimique est au moins une matière choisie dans le groupe consistant en l'acide chlorhydrique, l'acide acétique, le chlorure ferrique et un agent d'attaque à base d'oxyde tamponné.

6. Procédé suivant l'une des revendications 3 à 5, dans lequel la couche de catalyseur métallique est formée d'un métal choisi dans le groupe consistant en le nickel (Ni), le palladium (Pd), l'argent (Ag), l'or (Au), l'aluminium (Al), l'étain (Sn), l'antimoine (Sb), le cuivre (Cu), le terbium (Tb) et le cadmium (Cd).

7. Procédé suivant l'une des revendications 3 à 6, dans lequel le recuit est effectué à une température de 350 à 500°C.

8. Procédé suivant la revendication 5, dans lequel l'agent d'attaque chimique à base d'oxyde tamponné est un mélange de HF et de NH₄F.

9. Procédé suivant la revendication 3 ou 4, dans lequel l'épaisseur de la couche de diffusion va de 0,1 à 200 nm.
